# EUROPÄISCHE PATENTSCHRIFT

(11) **EP 2 422 976 B1**
(45) Veröffentlichungstag und Bekanntmachung des Hinweises auf die Patenterteilung: **08.03.2017**
(21) Anmeldenummer: 11159544.3
(22) Anmeldetag: 24.03.2011
(51) Int. Cl.: B32B 27/34, B32B 27/08, B32B 27/16, H01L 31/048

(54) **Photovoltaikmodul-Mehrschichtrückfolie sowie deren Herstellung und Verwendung bei der Produktion photovoltaischer Module**
Photovoltaic multi-layer backsheet, manufacture of same and use of same in the production of photovoltaic modules
Feuille arrière multicouche pour module photovoltaïque ainsi que sa fabrication et son utilisation dans la production de modules photovoltaïques

(30) Priorität: 30.07.2010 EP 10171458
(43) Veröffentlichungstag der Anmeldung: 29.02.2012
(73) Patentinhaber: EMS-PATENT AG, 7013 Domat / Ems (CH)
(72) Erfinder: Stöppelmann, Georg, Dr., 7402 Bonaduz (CH); Sturzel, André, 7206 Igis (CH); Etzel, Dietmar, 5408 Ennetbaden (CH); Pfleghar, Mark, 7013 Domat/Ems (CH)
(74) Vertreter: OK pat AG

(56) Entgegenhaltungen:
- EP-A1- 0 837 088
- EP-A2- 0 405 933
- WO-A1-2008/138022
- WO-A2-2006/023335
- JP-A- 4 059 353
- JP-A- 4 082 737
- JP-A- 2007 290 138
- US-A1- 2002 129 848
- US-A1- 2008 095 960
- US-B1- 6 740 375

## Beschreibung

Die Erfindung betrifft photovoltaische Module, d.h. Systeme zur photo-elektrischen Stromerzeugung. In einem solchen, im Wesentlichen flachen Photovoltaikmodul ist eine einzelne Solarzelle angeordnet oder eine Anzahl Solarzellen ist auf einer Fläche zusammengefasst und zusammengeschaltet. Solarzellen bestehen nach heutigem Stand der Technik meist aus einem Halbleitermaterial, welches das eingestrahlte Licht direkt in elektrische Energie umwandelt. Als Halbleitermaterial wird zu diesem Zweck hauptsächlich Silizium verwendet. In grösseren photovoltaischen Solaranlagen werden viele Module in Reihe geschaltet, was eine hohe elektrische Anlagen-Spannung und -Leistung ergibt.

Es ist bekannt, das klassische Siliziummaterial durch dünne Schichten zu ersetzen, wobei neben CdTe (Cadmiumtellurid) die Verbindung CuIn₁₋ₓGaₓSe₂ (CIGS) als eines der vielversprechendsten Materialien für Dünnschichtsolarzellen mit hoher Effizienz gilt (vgl. Homepage des EMPA, Laboratorium für dünne Schichten und Photovoltaik). Dieses EMPA-Institut erreichte mit CIGS auf Glassubstraten Effizienzen von bis zu 18.1%. Für flexible Dünnschichtsolarzellen auf Polymersubstraten wurde eine Effizienz von 17.6% durch das Fraunhofer Institut für solare Energiesysteme (ISE) in Freiburg (Deutschland) zertifiziert. Die Prozesse zur Solarzellenherstellung auf Polymerfolien können an die roll-to-roll-Produktion von monolithisch verschalteten Solarmodulen angepasst werden. Auch die Verwendung von organischen Halbleitern wird diskutiert (vgl. Carsten Deibel, Thomas Strobel, Vladimir Dyakonov: Origin of the Efficient Polaron-Pair Dissociation in Polymer-Fullerene Blends. In: Physical Review Letters; Phys. Rev. Lett. 103, 036402, publiziert am 16. Juli 2009). Hocheffiziente Photovoltaikelemente, die metallische Nanopartikel bzw. Nanostrukturen (jeweils zwischen einer n-dotierten oder p-dotierten Ladungs-Transportschicht platziert) enthalten sind aus US 2010/0000598 A1 bekannt.

Ein photovoltaisches Modul oder Photovoltaikmodul ist üblicherweise tafelförmig als Laminat aufgebaut: Zuoberst ist eine transparente Scheibe z.B. aus Spezialglas oder einem geeigneten transparenten Polymer oder einem transparenten Mehrschichtverbund angeordnet. Darunter schliesst eine Folie an, welche bevorzugt aus Ethylenvinylacetat (EVA) besteht, und welche die transparente Scheibe mit den eigentlichen Solarzellen (mehrere Siliziumscheiben oder auch nur eine einzelne Siliziumscheibe) verbindet bzw. einkapselt, um einen möglichen Feuchtigkeitseintritt zu verhindern. Eine weitere Folie aus EVA verbindet die Unterseiten der Solarzellen mit einer Rückfolie, welche die rückseitige Schutzschicht des Moduls darstellt. Der Verbund dieser Schichten wird jeweils in einer Vakuumpresse thermisch verfestigt (so dass die Schichten beim Heissverpressen über das EVA miteinander verkleben). Dabei werden die Schichtmaterialien zunächst in der umgekehrten Reihenfolge in die Presse hineingelegt, damit die Glasscheibe beim Laminieren als starre Unterlage für die anderen Schichten dienen kann. Auf diese Weise werden die Solarzellen im elastischen und transparenten EVA-Schmelzkleber eingebettet, und zwischen dem Glas und der Rückfolie eingekapselt, d.h. gegen Eintritt von Feuchtigkeit versiegelt. Neben EVA-Polymer, werden zunehmend weitere Einkapselungsmaterialien verwendet wie PVB, TPU oder Silicon-Polymere. Die Rückfolie eines solchen photovoltaischen Moduls ist der Hauptgegenstand der vorliegenden Erfindung.

Eine gute Beschreibung dieses technologischen Hintergrunds liefert die internationale Patentanmeldung WO 94/22172 A1. Als bevorzugte Rückfolie wird dort Tedlar^{®} (Handelsmarke von E. I. du Pont de Nemours and Company), eine Folie aus Polyvinylfluorid (PVF), genannt. Die Tedlar^{®}-Rückfolie kommt in der Praxis meist in Form einer dreischichtigen Folie (PVF/PET/PVF) zum Einsatz. WO 94/22172 A1 offenbart als mögliche Materialien für die rückseitige Modulschicht noch weitere thermoplastische Kunststoffe wie Polyolefine, Polyester, diverse Polyamide (Nylons), Polyetherketone, Fluorpolymere, etc.

Die Verwendung von Polyamid als Einkapselungsmaterial für photovoltaische Module steht im Zentrum der internationalen Patentanmeldung WO 2008/138021 A2.

Dieses Dokument weist einleitend auf den Stand der Technik mit den Mehrschichtfolienverbunden aus Fluorpolymer und Polyester (d.h. PVF und PET) als (rückseitiges) Einkapselungsmaterial hin. Weil die Haftung dieses Einkapselungsmaterials zum Einbettungsmaterial, dem Ethylenvinylacetat (EVA) gering sei, wird in der Patentanmeldung WO 2008/138021 A2 Polyamid (PA) als Einkapselungsmaterial, d.h. als Material für die Verwendung in Rückfolien von Photovoltaikmodulen, vorgeschlagen. Verschiedene Polyamidtypen werden explizit genannt: PA 6, PA 66, PA 7, PA 9, PA 10, PA 11, PA 12, PA 69, PA 610, PA 612, PA 6-3-T, PA 6I und Polyphthalamid (PPA). Im Dokument WO 2008/138021 A2 wird die Eignung der aufgezählten PA-Typen aber weder für die Verwendung in einem Folienverbund noch als Monofolie experimentell belegt.

Als mögliches Rückfolienmaterial wird Polyamid 11 auch im Fachartikel "Bio Based Backsheet" von S.B. Levy erwähnt, welcher in Proc. ofSPIE (2008) Vol. 7048 (Reliability of Photovoltaic Cells, Modules, Components, and Systems), 70480C/1-10 erschienen ist. In diesem Artikel wird Nylon 11 (d.h. PA 11) als ein sinnvolles Material für Rückfolien betrachtet, weil es auf einer nachwachsenden Rohstoffquelle basiert (Rizinusöl). Weiterhin wird offenbart, dass PA 11 trotzdem beständig ist (d.h. nicht biologisch abbaut), und somit von Interesse für einen Einsatz bei der umweltfreundlichen Sonnenenergiegewinnung ist. Zudem wird offenbart, dass in der Praxis das Nylon 11 nicht allein, sondern immer im Verbund mit einem anderen Folienmaterial (z.B. Cellulose) als Rückfolie eingesetzt würde.

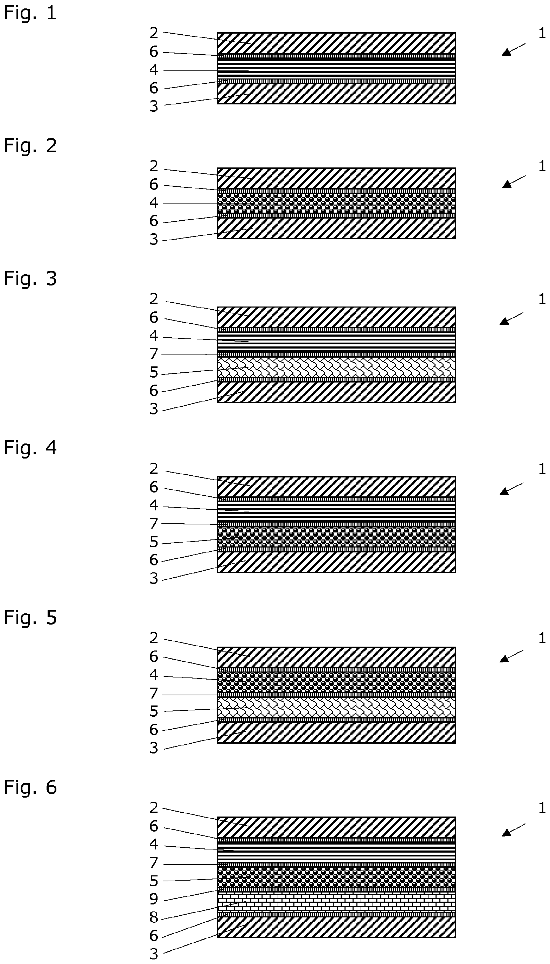

Zu demselben Schluss kommt auch US 2009/0101204 A1, als deren erster Erfinder ebenfalls S.B. Levy genannt ist. Hier wird das Polyamid 11 (nylon-11 layer 510) im Verbund mit einem speziellen, elektrisch isolierenden Papier (505) als Photovoltaik-Rückfolie (500) verwendet (vgl. Fig. 5 und entsprechende Erläuterungen). Das Polyamid 11 wird dabei durch Extrusionsbeschichtung auf das Papier aufgetragen.

WO 2008/138022 A1 beschreibt Polyamid 12 ebenfalls als Schichtmaterial für Schutzfolien von photovoltaischen Modulen und weist zudem darauf hin, dass entsprechende Folienverbunde hauptsächlich aus einer Trägermaterialschicht ausgewählt aus Polyester (PET oder PEN) oder dem Fluorpolymer ETFE bestehen.

Aus dem Stand der Technik sind Mehrschicht-Laminate als Photovoltaikmodul-Rückfolien bekannt. So offenbart z.B. die japanische Patentanmeldung mit der Publikationsnummer JP 2004-223925 A ein solches Mehrschicht-Laminat, das dicht ist gegen Feuchte und Penetration und das in hohem Masse wetterbeständig ist. Dabei besteht zumindest eine erste Schicht aus einem auf Polypropylen (PP) basierenden Harz. Eine zweite Schicht besteht aus Polyethylen (PE), das eine Dichte von 0.94 - 0.97 g/cm³ aufweist. Auf eine oder beide Oberflächen der ersten Schicht wird eine solche zweite Schicht auflaminiert.

Eine ähnliche Beständigkeit eines Mehrschicht-Laminats ist aus EP 1 956 660 A1 bekannt. Dieses Mehrschicht-Laminat umfasst eine hydrolyseresistente Schicht (aus einem Polyesterharz mit einem Carboxy-Endgruppen-Gehalt von höchstens 15 Äquivalenten pro Tonne) und eine auf diese hydrolyseresistente Schicht auflaminierte Schicht aus einem PP-Harz. Alternative, mittels PVD- oder CVD- ("Physical" oder "Chemical Vapor Deposition") hergestellte Barriereschichten aus Metalloxiden werden auch offenbart; als Ausgangsmaterialien werden beispielsweise Aluminium oder Silizium verwendet.

Eine andere Strategie verfolgt US 6,521,825 B2, indem eine Mehrschicht-Rückfolie bereitgestellt wird, die leicht und dünn ist, die dauerhaft ist und eine verbesserte Feuchtigkeitsresistenz besitzt, und die zudem ein guter elektrischer Isolator ist. Diese Mehrschicht-Rückfolie für Photovoltaikmodule umfasst eine gegen Feuchtigkeit beständige Mittelschicht, die zwischen zwei hitzeresistenten und witterungsbeständigen Schichten angeordnet ist. Dabei weist die gegen Feuchtigkeit beständige Mittelschicht eine Schicht aus einem anorganischen Oxid auf, die auf einer Oberfläche einer Grundschicht deponiert ist.

Eine weitere Strategie verfolgt WO 2009/085182 A2, indem eine koextrudierte Mehrschicht-Rückfolie bereitgestellt wird, die:
1) eine erste Aussenschicht mit einem Fluorpolymer (z.B. einem Polyvinylidenfluorid = PVDF),
2) eine Innenschicht, welche einen Polyester oder ein Polycarbonat (oder Kombinationen derselben) sowie einen Phasenvermittler auf Acryl-, Methacryl-Basis oder auf der Basis eines alkylischen Zinnoxids umfasst, und die
3) eine zweite Aussenschicht mit einem Fluorpolymer, einem Polyolefin oder einem Polyolefin-Schmelzkleber umfasst.

Weitere Mehrschicht-Rückfolien für Photovoltaikmodule auf der Basis von PVDF sind zudem z.B. aus den Dokumenten WO 94/22172 A1, WO 2008/157159 A1 bekannt. Dazu offenbart WO 2008/157159 A1, dass in Kombination mit Fluorpolymer-Schichten als brauchbare Barrieren gegen Wasserdampf Schichten aus Aluminium, Polyethylenterephthalat (PET), Polyethylennaphthalat (PEN) oder Ethylen/Vinylalkohol-Copolymer (EVOH) eingesetzt werden können. Dagegen offenbaren WO 2009/067422 A1 und WO 2009/111194 A1 Schichten auf der Basis von PVDF als Glasersatz zur Montage auf der vom Licht beschienenen Seite von Solarzellen.

Aus WO 2008/097660 A1 ist eine Solarzelle mit einer gegen das Licht gerichteten Seite und einer Rückseite bekannt. Die Solarzelle umfasst zudem eine starre Hüllschicht aus Polyvinylbutyral (PVB), die an die gegen das Licht gerichteten Seite oder an die Rückseite der Solarzelle anschliesst und eine PVB-Zusammensetzung umfasst, welche 10-23 Gewichts-% Weichmacher gemessen am Gesamtgewicht der PVB-Zusammensetzung umfasst und welche die Solarzelle in einer die PVB-Zusammensetzung umfassenden Polymermatrix umhüllt. Weitere Mehrschicht-Rückfolien für Photovoltaikmodule auf der Basis von PVB sind zudem z.B. aus dem Dokument WO 2008/138022 A1 bekannt.

Als weiteres mögliches Material für eine schützende Rückfolie in PhotovoltaikModulen ist aus der WO 2010/069546 A2 ein mit Polyamid gepfropftes Polyolefin bekannt, das reaktive Seitengruppen aufweist.

An aus diversen Polyamiden (PA 12, PA 1010, PA 610, PA 612 oder PA MACM12) hergestellten, einschichtigen Rückfolien für Photovoltaikmodule, d.h. an Photovoltaikmodul-Monorückfolien aus diesen Polyamiden, wurde festgestellt, dass Polyamide bei Temperaturen von 80 °C und höher relativ schnell zu vergilben beginnen. Bei aus solchen Polyamiden hergestellten Photovoltaikmodul-Rückfolien sinkt hiermit die an sich erwünschte Eigenschaft der Folie, Licht zu reflektieren. Wird jedoch die Folie dem Einfluss von Sauerstoff entzogen, lässt sich diese Vergilbung deutlich reduzieren. Zudem ist bekannt, dass die elektrischen Komponenten der Photovoltaikmodule feuchtigkeitsempfindlich sind. Im Dauerbetrieb in einem feuchten Klima kann die Funktionsfähigkeit der Photovoltaikmodule deutlich reduziert werden, wenn Wasserdampf durch das Material der Photovoltaikmodul-Rückfolien eindringt.

Der vorliegenden Erfindung liegt daher die Aufgabe zugrunde, eine alternative Photovoltaikmodul-Mehrschichtrückfolie mit verbesserter Wasserdampf- und Sauerstoff-Barrierewirkung vorzuschlagen.

Diese Aufgabe wird gemäss einem ersten Aspekt durch eine Photovoltaikmodul-Mehrschichtrückfolie mit den Merkmalen des Anspruchs 1 gelöst. Diese Photovoltaikmodul-Mehrschichtrückfolie umfasst eine erste Aussenschicht, eine zweite Aussenschicht und zumindest eine zwischen diesen Aussenschichten angeordnete, eine Wasserdampfbarriere und/oder Sauerstoffbarriere bildende Innenschicht, wobei diese Schichten aus Polymeren aufgebaut sind. Die erfindungsgemässe Photovoltaikmodul-Mehrschichtrückfolie ist dadurch gekennzeichnet, dass zumindest eine der beiden Aussenschichten ein Polyamid ausgewählt aus der Gruppe PA 12, PA 11, PA 610, PA 612, PA 1010, PA 1012, PA MACM12 sowie deren Mischungen umfasst, wobei die Polyamide einer oder beider Aussenschichten mindestens ein Weisspigment als Zusatzstoff enthalten. Dabei besteht die zumindest eine Innenschicht aus Polymeren, die ausgewählt sind aus der Gruppe, die aus PVDC, COC, PP, EVOH, PPS, PSU, PESU, PPSU, PEEK, LCP, PI, PAI und PBT besteht. Innenschichten aus PBT sind immer mittels mindestens einer äusseren Haftvermittlerschicht aus Block-Copolyesteramid mit mindestens einer der Polyamid umfassenden Aussenschichten verbunden.

Diese Aufgabe wird gemäss einem zweiten Aspekt durch ein Verfahren zur Herstellung einer Photovoltaikmodul-Mehrschichtrückfolie mit den Merkmalen des Anspruchs 16 gelöst. Diese Photovoltaikmodul-Mehrschichtrückfolie umfasst eine erste Aussenschicht, eine zweite Aussenschicht und zumindest eine zwischen diesen Aussenschichten angeordnete, eine Wasserdampfbarriere und/oder Sauerstoffbarriere bildende Innenschicht, wobei diese Schichten aus Polymeren aufgebaut sind. Das erfindungsgemässe Verfahren zur Herstellung einer Photovoltaikmodul-Mehrschichtrückfolie ist dadurch gekennzeichnet, dass zumindest eine der beiden Aussenschichten aus einem Polyamid ausgewählt aus der Gruppe PA 12, PA 11, PA 610, PA 612, PA 1010, PA 1012, PA MACM12 sowie deren Mischungen gebildet wird, wobei die Polyamide einer oder beider Aussenschichten mindestens ein Weisspigment als Zusatzstoff enthalten, und dass die zumindest eine Innenschicht aus einem Polymer ausgewählt aus der Gruppe, die aus PVDC, COC, PP, EVOH, PPS, PSU, PESU, PPSU, PEEK, LCP, PI, PAI und PBT besteht, gebildet wird. Innenschichten aus PBT werden nur in Kombination mit einer äusseren Haftvermittlerschicht aus Block-Copolyesteramid verwendet.

Weitere bevorzugte Merkmale der erfindungsgemässen Photovoltaikmodul-Mehrschichtrückfolie bzw. des erfindungsgemässen Verfahrens zur Herstellung einer Photovoltaikmodul-Mehrschichtrückfolie ergeben sich aus den jeweils abhängigen Ansprüchen. Die Verwendung solcher Photovoltaikmodul-Mehrschichtrückfolien erfolgt bevorzugt bei der Produktion photovoltaischer Module.

Im Zusammenhang mit der vorliegenden Erfindung werden folgende Definitionen angeführt:
Unter dem Begriff "Polyamid" werden verstanden:
   - Homopolyamide; und
   - Copolyamide.

Unter dem Begriff "Polyamidblends" werden verstanden:
- Mischungen (Blends) aus Homopolyamiden und Copolyamiden;
- Mischungen aus Homopolyamiden; und
- Mischungen aus Copolyamiden.

Unter dem Begriff "Polyamidformmasse" wird eine Formmasse verstanden, die Polyamide und/oder Polyamidblends enthält, wobei diese Polyamidformmasse Zusatzstoffe enthalten kann.

Vorteile der vorliegenden Erfindung umfassen:
1. In einer bevorzugten Ausführungsform der erfindungsgemässen Photovoltaikmodul-Mehrschichtrückfolie schützt eine Innenschicht aus PVDC die den Solarzellen am nächsten liegende Polyamid-Aussenschicht (und damit auch die elektrischen Komponenten der Solarzellen) vor allem gegen den Zutritt von Wasserdampf, und diese Polyamidschicht auch gegen den Zutritt von Luftsauerstoff und damit vor Vergilbung.
2. In einer bevorzugten Ausführungsform der erfindungsgemässen Photovoltaikmodul-Mehrschichtrückfolie schützt eine Innenschicht aus EVOH die den Solarzellen am nächsten liegende Polyamid-Aussenschicht vor allem gegen den Zutritt von Luftsauerstoff.
3. In einer besonders bevorzugten Ausführungsform der erfindungsgemässen Photovoltaikmodul-Mehrschichtrückfolie stellen eine Innenschicht aus PVDC und eine Innenschicht aus EVOH der den Solarzellen am nächsten liegenden Polyamid-Aussenschicht bzw. den Solarzellen einen verbesserten Schutz gegen den Zutritt von Wasserdampf und von Luftsauerstoff bereit.
4. In einer alternativen bevorzugten Ausführungsform der erfindungsgemässen Photovoltaikmodul-Mehrschichtrückfolie stellen eine Innenschicht aus COC und eine Innenschicht aus EVOH der den Solarzellen am nächsten liegenden Polyamid-Aussenschicht bzw. den Solarzellen einen verbesserten Schutz gegen den Zutritt von Wasserdampf und von Luftsauerstoff bereit.
5. In einer bevorzugten, besonders kostengünstigen Ausführungsform der erfindungsgemässen Photovoltaikmodul-Mehrschichtrückfolie stellen eine Innenschicht aus PP und eine Innenschicht aus EVOH der den Solarzellen am nächsten liegenden Polyamid-Aussenschicht bzw. den Solarzellen einen verbesserten Schutz gegen den Zutritt von Wasserdampf und von Luftsauerstoff bereit.
6. Die erfindungsgemässen Photovoltaikmodul-Mehrschichtrückfolien verhindern (insbesondere durch die erhöhte Sperrwirkung gegenüber Luftsauerstoff) effektiv ein Vergilben der den Solarzellen am nächsten liegenden Polyamid-Aussenschicht, die damit ihre Eigenschaften als weisse Reflexionsschicht hinter den Solarzellen in vollem Umfang beibehält, und so die elektrische Ausbeute der Solarzellen hoch bleibt.
7. Die erfindungsgemässen Photovoltaikmodul-Mehrschichtrückfolien ermöglichen (insbesondere durch die erhöhte Sperrwirkung gegenüber Wasserdampf) effektiv, dass die den Solarzellen am nächsten liegende Polyamid-Aussenschicht ihre Eigenschaft als elektrische Isolationsschicht in vollem Umfang beibehält, und so die Funktionsfähigkeit der elektrischen Komponenten nicht durch eventuelle Kurzschlussströme beeinträchtigt wird.
8. Bei Verwendung einer Barriereschicht aus PBT in Kombination mit Block-Copolyesteramid als Haftvermittlerschicht zu der oder den Aussenschichten aus Polyamid kann eine solche erfindungsgemässe Photovoltaikmodul-Mehrschichtrückfolie sehr wirtschaftlich in einem Schritt durch Co-Extrusion hergestellt werden, weil auf eine Laminierung von Einzelfolien mittels Klebern verzichtet werden kann.

Es soll an dieser Stelle zum Verständnis noch angemerkt werden, dass die den Solarzellen am nächsten liegende bzw. zugewandte Aussenschicht der Mehrschichtrückfolie nach dem Zusammenfügen mit den anderen Teilen in der thermischen Vakuumpresse, nachher am kompletten und fertigen Photovoltaikmodul betrachtet, am Schluss natürlich keine Aussenschicht mehr darstellt, sondern eine Zwischenschicht.

Die beiliegenden Figuren stellen bevorzugte Ausführungsbeispiele der vorliegenden Erfindung dar und dienen lediglich zu deren Illustration, nicht aber zum Einschränken des Erfindungsumfangs. Dabei zeigen:
- Fig. 1: eine Photovoltaikmodul-Mehrschichtrückfolie mit zwei Aussenschichten und einer Innenschicht, gemäss einer ersten Ausführungsform;
- Fig. 2: eine Photovoltaikmodul-Mehrschichtrückfolie mit zwei Aussenschichten und einer Innenschicht, gemäss einer zweiten Ausführungsform;
- Fig. 3: eine Photovoltaikmodul-Mehrschichtrückfolie mit zwei Aussenschichten und zwei Innenschichten, gemäss einer dritten Ausführungsform;
- Fig. 4: eine Photovoltaikmodul-Mehrschichtrückfolie mit zwei Aussenschichten und zwei Innenschichten, gemäss einer vierten Ausführungsform;
- Fig. 5: eine Photovoltaikmodul-Mehrschichtrückfolie mit zwei Aussenschichten und zwei Innenschichten, gemäss einer fünften Ausführungsform;
- Fig. 6: eine Photovoltaikmodul-Mehrschichtrückfolie mit zwei Aussenschichten und drei Innenschichten, gemäss einer sechsten Ausführungsform.

Die Figur 1 zeigt eine Photovoltaikmodul-Mehrschichtrückfolie 1, die eine erste Aussenschicht 2, eine zweite Aussenschicht 3 und eine zwischen diesen Aussenschichten 2,3 angeordnete, eine Wasserdampfbarriere und/oder Sauerstoffbarriere bildende Innenschicht 4 umfasst, wobei diese Schichten aus Polymeren aufgebaut sind. Zumindest eine der beiden Aussenschichten 2,3, bevorzugt aber beide Aussenschichten 2,3, umfassen ein Polyamid, wobei beide Aussenschichten 2,3 in einer speziell bevorzugten Variante dieser ersten Ausführungsform aus dem gleichen Polyamid bestehen.

Die Polyamide einer oder beider Aussenschichten enthalten mindestens ein Weisspigment als Zusatzstoff. Die den Solarzellen am nächsten liegende Aussenschicht der Rückfolie kann transparent sein, damit eine darunter liegende Innenschicht als Reflexionsschicht ausgebildet sein kann, indem sie ein Weisspigment enthält. Bevorzugt wird eine Reflektivität von mindestens 92 %, wobei das Weisspigment vorzugsweise Titandioxid ist. Alternativ und bevorzugt kann auch die den Solarzellen am nächsten liegende Aussenschicht der Rückfolie als Reflexionsschicht ausgebildet sein und ein Weisspigment (vorzugsweise Titandioxid) enthalten, das bevorzugt eine Reflektivität von mindestens 92 % ergibt.

Transparente Polyamide sind aus aliphatischen, cycloaliphatischen und/oder aromatischen Monomeren aufgebaut und umfassen sowohl Homopolyamide als auch Copolyamide. Sowohl amorphe als auch mikrokristalline Polyamide sind transparent. Mikrokristalline Polyamide sind nicht mehr völlig amorph, sie weisen aber auf Grund ihrer mikrokristallinen Struktur Kristallite auf, die kleiner als die Wellenlänge des Lichtes und somit nicht sichtbar sind. Mikrokristalline Polyamide sind deshalb für das Auge noch durchsichtig. Ein besonders bevorzugtes transparentes Polyamid ist dabei das Homopolyamid PA MACM12.

Beim Polyamid für zumindest eine Aussenschicht oder beide Aussenschichten 2,3 handelt es sich um auf der Basis linearer und/oder verzweigter aliphatischer und/oder cycloaliphatischer Monomere aufgebaute Polyamide, die ausgewählt sind aus der Gruppe PA 11, PA 12, PA 610, PA 612, PA 1010, PA 1012 und PA MACM12 oder Mischungen derselben.

Die Monomere sind ausgewählt aus der Gruppe, die aus Diaminen, Dicarbonsäuren, Lactamen und Aminocarbonsäuren sowie Mischungen derselben besteht. Die auf Lactamen und Aminocarbonsäuren basierenden Polyamide sind vorzugsweise vernetzt. Die auf Diaminen und Dicarbonsäuren basierenden Polyamide aus dem genannten Bereich stellen sowohl in unvernetzter als auch in vernetzter Form bevorzugte Varianten dar. In einer weiteren Variante könnte das Polyamid zwar noch unvernetzt sein, aber bereits einen Vernetzungsaktivator wie z.B. TAIC enthalten, der im Falle eines Brandes zum Vernetzen führen würde und so das Abtropfen des Polyamids verhindern könnte.

Das Polyamid kann neben aliphatischen Monomeren wie gesagt auch cycloaliphatische Monomere enthalten, von denen folgendes bevorzugt ist: MACM (= 3,3'-Dimethyl-4,4'-diaminodicyclohexylmethan).

In bevorzugten Ausführungsformen ist das Polyamid ausgewählt aus der Gruppe

Polyamid 1010, Polyamid 1010 vernetzt, Polyamid 11 vernetzt, Polyamid 12 vernetzt, Polyamid 1012, Polyamid 1012 vernetzt, Polyamid MACM12, Polyamid MACM12 vernetzt, und Mischungen davon. Besonders bevorzugt ist das Polyamid ausgewählt aus der Gruppe Polyamid 1010 und Polyamid 1010 vernetzt sowie Polyamid 12 vernetzt. Auch können die beiden Aussenschichten 2,3 unterschiedliche Polyamide und/oder Polyamidblends aufweisen (vgl. Tabelle 1).

Die zumindest eine Innenschicht 4,5 besteht aus einem Polymer, das kein Fluorpolymer ist, wobei überdies Polyethylen als Innenschicht ausgeschlossen ist. Bevorzugt für die Innenschicht sind Polymere mit Barriereeigenschaften gegenüber Wasserdampf und/oder Sauerstoff. Falls gemäss Anspruch 1 bzw. Anspruch 16 PBT als Barrierepolymer für die Innenschicht ausgewählt wird, so wird PBT bei den erfindungsgemässen Photovoltaikmodul-Mehrschichtrückfolien 1 ausschliesslich in Kombination mit mindestens einer Haftvermittlerschicht aus Block-Copolyesteramid verwendet. Eine solche Kombination von PBT mit einem Block-Copolyesteramid-Haftvermittler wird durch WO 2008/138022 A1 nicht nahegelegt.

Ein besonders bevorzugtes Material für die zumindest eine Innenschicht 4,5 ist Polyvinylidenchlorid (PVDC). Ein solches PVDC-Material ist unter dem Handelsnamen IXAN^{®} PV 910 bekannt (SolVin S.A., B-1120 Brüssel, Belgien). Dabei handelt es sich um einen PVDC-Blend mit 2% epoxidiertem Sojaöl, der sich zur Extrusion und Coextrusion von Folien (mit EVA oder PE) zur Verpackung von Lebensmitteln eignet. Diese Folien können unter anderem auch Heiss-Schrumpf-Folien oder hitzeformbare Folien sein. Das Material hat eine Schmelztemperatur von 155 °C, und eine niedrige Durchlässigkeit für Wasserdampf und Sauerstoff.

Es ist bekannt, dass bei den Verarbeitungstemperaturen für kompaktes PVDC (160 °C bis 170 °C) die Zersetzung des Materials unter HCl-Abspaltung beginnt, so dass Verarbeitungsmaschinen bei der Extrusion durch Korrosion erheblich geschädigt werden können. Deshalb werden bevorzugt Copolymere aus PVDC mit Vinylchlorid (5-20%) oder mit Vinylchlorid (13%) und Acrylnitril (2%) verarbeitet. Um beim Hersteller einer Mehrschichtfolie das (Co-)Extrudieren von PVDC zu umgehen, ist auch das Laminieren der beiden Aussenschichten 2,3 auf die zumindest eine Innenschicht 4,5 aus PVDC in Form einer bereits vorhandenen PVDC-Folie speziell bevorzugt. Eine andere alternative Möglichkeit wäre es, PVDC als Suspension auf eine Aussenschichtfolie aufzutragen.

Als alternatives Material für die zumindest eine Innenschicht 4,5 kommen zyklische Olefin-Copolymere (COC) in Frage. Zyklische Olefin-Copolymere (COC, Markenname TOPAS^{®}; Topas Advanced Polymers GmbH, D-95926 Frankfurt, Deutschland) sind bekannt dafür, dass sie hervorragende Wasser abstossende Eigenschaften aufweisen bzw. eine sehr gute Wasserdampfbarriere darstellen. Auf Grund ihres olefinischen Charakters sind COC-Produkte resistent gegenüber Hydrolyse, Säuren und Laugen sowie gegenüber polaren Lösungsmitteln wie z.B. Methanol. Allerdings können COC-Produkte durch nichtpolare, organische Lösungsmittel wie z.B. Toluol beschädigt werden. Da TOPAS^{®} COC Harze empfindlich gegenüber Ultraviolett-Strahlung sind, wird die Verwendung von UV-Stabilisatoren empfohlen. Beim Einsatz von COC-Innenschichten wird vorzugsweise mit Maleinsäureanhydrid funktionalisiertes COC verwendet, zwecks Erzielung einer besseren Adhäsion.

Als weiteres alternatives Material für die zumindest eine Innenschicht 4,5 kommt EVOH in Frage, insbesondere wegen der ausgezeichneten Sauerstoffbarriere. Zudem kommt Polypropylen (PP) als weiteres Material für die zumindest eine Innenschicht 4,5 in Frage, weil es eine recht gute Wasserdampfbarriere bereitstellt (vgl. Tabelle 2) und sich damit insbesondere zum Kombinieren mit einer EVOH-Schicht eignet (vgl. Tabelle 1). Das aus JP 2004-223925 A bekannte Polyethylen (PE) kommt, obwohl es eine gute Wasserdampfbarriere bereitstellt, für die zumindest eine Innenschicht 4,5 bei der vorliegenden Erfindung nicht in Frage, weil dessen Schmelzpunkt von 135 °C zu niedrig ist für die Herstellung der fertigen Photovoltaikmodule, da in der Vakuumpresse zum Laminieren des Gesamtmoduls üblicherweise Temperaturen in der Grössenordnung von 140-150 °C angewandt werden.

Das Material für die zumindest eine Innenschicht 4,5 ist somit bevorzugt ausgewählt aus einer Gruppe, die PVDC, COC, PP und EVOH sowie Kombinationen davon umfasst. Zusätzliche bevorzugte Materialien für die mindestens eine Innenschicht, die von dieser Gruppe ebenfalls umfasst werden, sind PPS (Polyphenylensulfid), PSU (Polysulfon), PESU (Polyethersulfon), PPSU (Polyphenylsulfon), PEEK (Polyetheretherketon), flüssigkristalline Polymere (LCP = liquid crystalline polymers), Polyimid (PI) und Polyamidimid (PAI). Bevorzugte Kombinationen für zwei Innenschichten 4,5 können gebildet werden aus PVDC + EVOH oder COC + EVOH oder PP + EVOH, wobei die Kombination PVDC + EVOH besonders bevorzugt ist.

Zur besseren Haftung der Schichten untereinander kann zwischen zumindest einer Oberfläche der Innenschicht 4,5 und einer inneren Oberfläche einer oder beider Aussenschichten 2,3 eine Haftvermittlerschicht 6 angeordnet sein. Dies ist jedoch nur dann notwendig, wenn die beiden Aussenschichten 2,3 materialbedingt keine spontane Haftverbindung mit der Innenschicht 4,5 eingehen. Analog kann eine Haftvermittlerschicht 7 auch zwischen zwei Innenschichten 4,5 vorgesehen werden. Das Material für die Haftvermittlerschichten 6,7,9 ist vorzugsweise ausgewählt aus der Gruppe, die Acrylate, Epoxide, PUR (Polyurethan), funktionalisierte Polyolefine (z.B. auf Basis EPM oder EPDM), Ionomere sowie Ethylenvinylacetat (EVA) umfasst.

In einer alternativen Variante der erfindungsgemässen Photovoltaikmodul-Mehrschichtrückfolie 1 ist das Material für die zumindest eine Innenschicht 4,5 PBT (Polybutylenterephthalat). Diese Innenschicht ist immer kombiniert mit mindestens einer daran angrenzenden Haftvermittlerschicht aus Block-Copolyesteramid mit zu den benachbarten Schichten verträglichen Blöcken, welche die PBT-Schicht mit mindestens einer Polyamid-Aussenschicht verbindet.

Bevorzugt entsprechen dabei die Blöcke des Block-Copolyesteramids einerseits dem PBT und anderseits dem Polyamid, an welche die Haftvermittlerschicht aus Block-Copolyesteramid angrenzt, denn stofflich identische Blöcke in Bezug auf die benachbarte Polymerschicht ergeben die beste Verträglichkeit bzw. Haftung.

In einer bevorzugten Ausführungsform ist die PBT-Schicht beidseitig über je eine Haftvermittlerschicht aus Block-Copolyesteramid mit zwei Aussenschichten 2,3 aus Polyamid verbunden.

Die Verwendung eines Block-Copolyesteramids als Haftvermittlerschicht ermöglicht die Herstellung einer fertigen Rückfolie in einem Schritt durch Co-Extrusion, d.h. eine solche Photovoltaikmodul-Mehrschichtrückfolie ist bevorzugt coextrudiert.

Eine vorteilhafte Photovoltaikmodul-Mehrschichtrückfolie mit einer Innenschicht aus PBT und Block-Copolyesteramid als Haftvermittler (HV) kann z.B. folgende Struktur aufweisen: Polyamid 12 / HV / PBT / HV / Polyamid 12. In diesem Fall ist der Block-Copolyesteramid-Haftvermittler bevorzugt aufgebaut aus Polyamid 12- und PBT-Blöcken. Ein solcher Haftvermittler ist unter der Bezeichnung Grilamid^{®} EA20HV1 bei der EMS-CHEMIE AG (Domat/Ems, Schweiz) erhältlich.

Bevorzugt wäre auch die analoge Struktur einer Photovoltaikmodul-Mehrschichtrückfolie mit einer Innenschicht aus PBT und Block-Copolyesteramid als Haftvermittler, bei welcher PA 1010 die Polyamid-Aussenschichten bildet: Polyamid 1010 / HV / PBT / HV / Polyamid 1010.

Bei einem Verfahren zur Herstellung einer erfindungsgemässen Photovoltaikmodul-Mehrschichtrückfolie 1 kann einer Polyamidschmelze zur Erzielung einer Vernetzung des Polyamids ein Vernetzungsaktivator zugegeben werden. Der Vernetzungsaktivator wird bevorzugt ausgewählt aus der Gruppe Trimethylolpropantrimethacrylat und Triallylisocyanurat (TAIC).

Vorzugsweise werden die beiden Aussenschichten 2,3 als zunächst separate Folien extrudiert und auf die beiden Oberflächen der Innenschicht 4 kaschiert oder laminiert. Alternativ können beide Aussenschichten 2,3 und die Innenschicht 4 als Schmelzeschichten direkt zu einer Mehrschichtfolie coextrudiert werden. Letzteres ist wie erwähnt insbesondere im Fall von PBT in Kombination mit Block-Copolyesteramid besonders bevorzugt.

Wenn ein Vernetzungsaktivator im Polyamid enthalten ist, kann eine Vernetzung an den extrudierten Folien vorzugsweise durch energiereiche Bestrahlung, beispielsweise durch Elektronenbestrahlung ausgelöst werden, entweder an den separaten Polyamid-Einzelfolien oder an der Mehrschichtfolie.

Mit einem Vernetzungsaktivator, aber ohne Bestrahlung, hat man die Variante eines vernetzbaren, aber noch nicht vernetzten Polyamids. Eine solche Variante macht Sinn, wenn man im Normalzustand die Vernetzung von den Eigenschaften her nicht braucht, aber im Notfall bei einem Brand das Abtropfen von Polyamid verhindert werden soll. Dann wird die Vernetzung im Ereignisfall gerade durch die thermische Energie des Brandes ausgelöst.

Die Polyamid-Formmasse der erfindungsgemässen Rückfolie enthält bevorzugterweise mindestens einen weiteren Zusatzstoff, ausgewählt aus UV-Stabilisatoren, UV-Absorbern, Antioxidantien, Hitzestabilisatoren, Hydrolysestabilisatoren, Vernetzungsaktivatoren, Flammschutzmitteln, Nanofüllstoffen wie insbesondere Schichtsilikaten, Füllstoffen, Farbmitteln (umfassend Farbstoffe und Farbpigmente), Verstärkungsmitteln, Haftvermittlern und Schlagzähigkeitsmodifikatoren. Mit Schichtsilikaten kann die Wasserdampfbarriere des Polyamidmaterials bzw. der Rückfolie weiter verbessert werden. Schichtsilikate verbessern zudem die thermooxidative Beständigkeit der Polyamid-Formmasse und erhöhen die Dimensionsstabilität (geringeres Nachschwinden bei der Folienherstellung und geringerer Wärmeausdehnungskoeffizient).

Beim Weisspigment, das die gewünschte hohe Reflektivität ergibt, handelt es sich bevorzugt um Titandioxid (bevorzugt in der Rutil-Kristallmodifikation). Titandioxid wirkt gleichzeitig auch als UV-Absorber. Andere mögliche Weisspigmente sind z.B. Zinkoxid und Zinksulfid. Die mit Weisspigmenten erzielte Reflektivität der Rückfolie beträgt bevorzugt mindestens 92 %.

Wünschbar ist es, wenn Backsheets für Photovoltaikmodule zudem gewisse Anforderungen hinsichtlich des Verhaltens bei einem Brand und Feuerausbreitung erfüllen, wie sie z.B. in der US-Norm UL 790 (Standard Test Methods for Fire Tests of Roof Coverings) beschrieben sind. Die Rückfolien müssen nicht unbedingt flammhemmend sein, aber zumindest sollen diese Polymere bzw. Polyamide in einer Flamme bzw. wenn sie selbst brennen wenn möglich nicht tropfen oder abfallen, weil brennende Tropfen einen Brand schnell auf die unteren Böden eines Hauses verteilen könnten. Bezüglich des Tropfens haben die Erfinder festgestellt, dass vernetzte Polyamide bei Kontakt mit einer Flamme praktisch nicht tropfen, im Gegensatz zu normalen, unvernetzten Polyamiden. Zusätzlich oder alternativ können die Polymere bzw. Polyamide Flammschutzmittel enthalten und damit flammhemmend ausgerüstet sein. Besonders bevorzugt unter diesen Gesichtspunkten sind die Polyamide PA 1010 vernetzt und PA 12 vernetzt. Optional sind zusätzlich Flammschutzmittel möglich. Flammschutzmittel können in mehrere Schichten eingebaut werden.

Durch die Auswahl des Polyamids aus dem beanspruchten Bereich für die Aussenschichten 2,3 und des Materials für die zumindest eine Innenschicht 4,5, sowie dem Zusetzen eines oder mehrerer Zusatzstoffe, erfüllt die erfindungsgemässe Photovoltaikmodul-Mehrschichtrückfolie 1 alle wesentlichen Anforderungen an eine solche Rückfolie, wie Witterungsstabilität (UV- und Hydrolysebeständigkeit), Hitzebeständigkeit, mechanischer Schutz, elektrische Isolierung, hohe Reflektivität und gute Haftung. Bei einer solchen, erfindungsgemässen Mehrschichtlösung mit einer (oder mehreren) ausgewählten Innenschicht(en) sind insbesondere die Verbesserung der Wasserdampf- und Sauerstoffbarriere, die Senkung der Wärmeausdehnung zwischen -30 °C und +80 °C sowie das Erreichen eines relativen Temperaturindexes (RTI) von > +105 °C erwähnenswert. Vergleichbare Werte können mit Monofolien nicht erreicht werden.

Zur Herstellung der erfindungsgemässen Photovoltaikmodul-Mehrschichtrückfolie 1 wird am besten das Verfahren der Extrusion oder der Laminierung bzw. Kaschierung angewandt. Wenn dabei eine Vernetzung des Polyamids erzielt werden soll, so wird der Polyamid-Formmasse vor der Formgebung ein Vernetzungsaktivator zudosiert. Bevorzugte Vernetzungsaktivatoren sind z.B. TMPTMA (= Trimethylolpropantrimethacrylat) und TAIC (= Triallylisocyanurat). Die Vernetzung kann bei entsprechendem Aktivator schon bei der Compoundierung bzw. Folienextrusion in-line auf radikalische Art durchgeführt werden. Bevorzugt wird die Vernetzung aber hinterher an der extrudierten Folie durch energiereiche Bestrahlung ausgelöst. Die energiereiche Bestrahlung erfolgt vorzugsweise durch Elektronenbestrahlung.

Die so hergestellte Rückfolie der erfindungsgemässen Zusammensetzung wird zur Herstellung photovoltaischer Module verwendet.

Die Varianten mit dem vernetzten Polyamid 11 sowie dem Polyamid 1010 (unvernetzt und vernetzt), und dem Polyamid 1012 (unvernetzt und vernetzt) können übrigens das ökologische Argument geltend machen, dass sie auf einer nachwachsenden Rohstoffbasis beruhen, denn Rizinusöl ist nicht nur die Ausgangsbasis zur Herstellung des PA11-Monomers, sondern auch für die Sebacinsäure (Decandisäure) und Decandiamin, welche zur Synthese von Polyamiden mit 10er-Disäure und/oder 10er-Diamin dienen. Bevorzugt umfasst die erste Ausführungsform der in der Figur 1 dargestellten, laminierten Photovoltaikmodul-Mehrschichtrückfolie 1 zwei Aussenschichten 2,3 aus einem vernetzten Polyamid PA 1010 und eine Innenschicht 4 aus PVDC.

Die Figur 2 zeigt ebenfalls eine Photovoltaikmodul-Mehrschichtrückfolie 1, die eine erste Aussenschicht 2, eine zweite Aussenschicht 3 und eine zwischen diesen Aussenschichten 2,3 angeordnete, eine Wasserdampfbarriere und/oder Sauerstoffbarriere bildende Innenschicht 4 umfasst, wobei diese Schichten aus Polymeren aufgebaut sind. Alle Ausführungen zur Figur 1 treffen auch hier zu. Bevorzugt umfasst die zweite Ausführungsform der in der Figur 2 dargestellten, coextrudierten Photovoltaikmodul-Mehrschichtrückfolie 1 zwei Aussenschichten 2,3 aus einem Polyamid PA MACM12 und eine Innenschicht 4 aus mit Maleinsäureanhydrid funktionalisiertem COC.

Die Figur 3 zeigt eine Photovoltaikmodul-Mehrschichtrückfolie 1 mit zwei Aussenschichten 2,3 und zwei Innenschichten 4,5, gemäss einer dritten Ausführungsform. Diese zwei Innenschichten 4,5 bilden eine Wasserdampfbarriere und/oder Sauerstoffbarriere. Alle diese Schichten sind aus Polymeren aufgebaut. Alle Ausführungen zur Figur 1 treffen sinngemäss auch hier zu; allerdings kann hier eine der beiden Innenschichten 4,5 Schichten aus EVOH gebildet sein. Bevorzugt umfasst die dritte Ausführungsform der in der Figur 3 dargestellten, laminierten Photovoltaikmodul-Mehrschichtrückfolie 1 zwei Aussenschichten 2,3 aus einem Polyamid PA MACM12, eine Innenschicht 4 aus PVDC und eine Innenschicht 5 aus EVOH.

Die Figur 4 zeigt ebenfalls eine Photovoltaikmodul-Mehrschichtrückfolie 1 mit zwei Aussenschichten 2,3 und zwei zwischen diesen Aussenschichten 2,3 angeordnete, eine Wasserdampfbarriere und/oder Sauerstoffbarriere bildenden Innenschichten 4,5. Alle Ausführungen zur Figur 3 treffen auch hier zu. Bevorzugt umfasst die vierte Ausführungsform der in der Figur 4 dargestellten, laminierten Photovoltaikmodul-Mehrschichtrückfolie 1 zwei Aussenschichten 2,3 aus einem vernetzten Polyamid PA 1010, eine Innenschicht 4 aus PVDC und eine Innenschicht 5 aus COC.

Die Figur 5 zeigt ebenfalls eine Photovoltaikmodul-Mehrschichtrückfolie 1 mit zwei Aussenschichten 2,3 und zwei zwischen diesen Aussenschichten 2,3 angeordneten, eine Wasserdampfbarriere und/oder Sauerstoffbarriere bildenden Innenschichten 4,5. Alle Ausführungen zur Figur 3 treffen auch hier zu. Bevorzugt umfasst die fünfte Ausführungsform der in der Figur 5 dargestellten, coextrudierten Photovoltaikmodul-Mehrschichtrückfolie 1 zwei Aussenschichten 2,3 aus einem vernetzten Polyamid PA MACM12, eine Innenschicht 4 aus COC und eine Innenschicht 5 aus EVOH.

Die Figur 6 zeigt eine Photovoltaikmodul-Mehrschichtrückfolie 1 mit zwei Aussenschichten 2,3 und drei zwischen diesen Aussenschichten 2,3 angeordneten, eine Wasserdampfbarriere und/oder Sauerstoffbarriere bildenden Innenschichten 4,5,8. Alle diese Schichten sind aus Polymeren aufgebaut. Alle Ausführungen zur Figur 1 oder zur Figur 3 treffen sinngemäss auch hier zu. In diesem Fall umfasst die Photovoltaikmodul-Mehrschichtrückfolie 1 zumindest drei Innenschichten 4,5,8. Als zweite oder dritte Innenschichten 5,8 verwendbare Barriere-Polymere sind PPS (Polyphenylensulfid), PSU (Polysulfon), PESU (Polyethersulfon), PPSU (Polyphenylsulfon), PAI (Polyamidimid), PI (Polyimid) und PEEK (Polyetheretherketon).

In allen Figuren liegen die übrigen Komponenten des Photovoltaik-Moduls (jeweils nicht dargestellt) auf der obersten gezeichneten Aussenschicht 2. Bei zwei oder drei Innenschichten kann die Reihenfolge der Barriereschichten auch anders gewählt werden als in den Figuren dargestellt.

Alternative Ausführungsformen der erfindungsgemässen Photovoltaikmodul-Mehrschichtrückfolie 1 umfassen folgende, in der Tabelle 1 dargestellte Beispiele, welche lediglich ein Auswahl bevorzugter Schicht-Kombinationen darstellen und keinesfalls limitierend zu verstehen sind:

**Tabelle 1**

| **AS 2** | **HV** | **IS 4** | **HV** | **IS 5** | **HV** | **AS 3** |
|---|---|---|---|---|---|---|
| PA 12 | + | PVDC | | | + | PA 12 |
| PA 12 | + | EVOH | | | + | PA 12 |
| PA 12 | + | COC | | | + | PA 12 |
| PA 12 | + | PVDC | + | EVOH | + | PA 12 |
| PA 12 | + | COC | + | EVOH | + | PA 12 |
| PA 12 | + | EVOH | + | PP | + | PA 12 |
| PA 1010 | + | PVDC | | | + | PA 1010 |
| PA 1010 | + | EVOH | | | + | PA 1010 |
| PA 1010 | + | COC | | | + | PA 1010 |
| PA 1010 | + | PVDC | + | EVOH | + | PA 1010 |
| PA 1010 | + | COC | + | EVOH | + | PA 1010 |
| PA 1010 | + | PVDC | + | EVOH | + | PA 12 |
| PA 1010 | + | COC | + | EVOH | + | PA 12 |
| PA MACM12 | + | PVDC | | | + | PA MACM12 |
| PA MACM12 | + | EVOH | | | + | PA MACM12 |
| PA MACM12 | + | COC | | | + | PA MACM12 |
| PA MACM12 | + | PVDC | + | EVOH | + | PA MACM12 |
| PA MACM12 | + | COC | + | EVOH | + | PA MACM12 |

Dabei bedeuten:
AS = Aussenschicht; HV = Haftvermittlerschicht; IS = Innenschicht

Als Beispiele für in der Tabelle 1 aufgelistete Werkstoffe werden in der folgenden Tabelle 2 einige ausgewählte, normierte Permeationswerte angegeben:

**Tabelle 2**

| Werkstoffbezeichnung | Sauerstoffdurchlässigkeit [cm³*mm/m²*Tag*bar] bei 23°C/85% Luftfeuchte | Wasserdampfdurchlässigkeit [g*mm/m²*Tag] bei 23°C/85% Luftfeuchte |
|---|---|---|
| Polyamid 12 (Grilamid L20) | 19 [1] | 8 [1] |
| PA MACM12 (Grilamid TR 90) | 30 [1] | 13 [1] |
| EVOH (EVAL EF-F) | 0.05 [2] | 0.8 [2] |
| PVDC (Saran 100 HB | 0.31 [2] | 0.02 [2] |
| COC (Ticona Topas) | 71 [2] | 0.03 [2] |
| Polypropylen (PP) | 110 [2] | 0.4 [2] |

| | | |
|---|---|---|
| Legende: [1] Werte intern gemessen bei EMS nach DIN/ISO 15105-1 (O₂) bzw. DIN/ISO 15106-1 (H₂O) [2] Werte aus Literatur : Permeability Properties of Plastics and Elastomers, Liesl K. Massey, 2003, Plastics Design Library. | | |

Aus den Permeationswerten in der Tabelle 2 werden die nachfolgend angeführten, beispielhaften Durchlässigkeiten berechnet. Um die aktuelle Permeation für eine Monofolie angeben zu können, werden die normierten Permeationswerte jeweils durch die aktuelle Schichtdicke (in mm) dividiert. Bei Mehrschichtfolien ist (analog zu einem elektrischen Widerstand) bei jeder einzelnen Schicht der Kehrwert der Einzel-Permeation zu betrachten; für die Berechnung der Gesamtpermeation sind die Kehrwerte der Einzelpermeationen zu addieren, und von dieser Summe ist (analog zum Stromfluss durch eine Serienschaltung von elektrischen Widerständen) der Kehrwert zu berechnen.

| | |
|---|---|
| Vergleichsbeispiel : | Monofolie |
| Werkstoff: | PA 12 |
| Totale Dicke: | 300 µm |
| Sauerstoffdurchlässigkeit: | 63.3 [cm³/m²*Tag*bar], |
| Wasserdampfdurchlässigkeit: | 26.7 [g/m²*Tag] |
| Beispiel : | Mehrschichtfolie |
| Werkstoffe: | PA 12 (125 µm) / PVDC (50 µm) / PA 12 (125 µm) |
| Totale Dicke: | 300 µm |
| Sauerstoffdurchlässigkeit: | 5.7 [cm³/m²*Tag*bar] |
| Wasserdampfdurchlässigkeit: | 0.40 [g/m²*Tag] |

### (Die Haftvermittlerschichten sind hier nicht berücksichtigt)

Der Vergleich der Monofolie (Vergleichsbeispiel) mit einer insgesamt gleich dicken, erfindungsgemässen Mehrschichtfolie (Beispiel) zeigt an Hand der berechneten Durchlässigkeiten, wie drastisch die Permeation mit einer Barrierefolie reduziert werden kann. Tatsächlich wird durch die erfindungsgemässe Mehrschichtfolie die Sauerstoffdurchlässigkeit gegenüber dem Vergleichsbeispiel um etwa einen Faktor 11 und die Wasserdampfdurchlässigkeit gegenüber dem Vergleichsbeispiel um etwa einen Faktor 66 verringert.

Für den Fachmann war es, insbesondere wegen der zum Teil schwierig zu verarbeitenden Werkstoffe (z.B. PVDC), nicht naheliegend, die eher von der Lebensmittelverpackungs-Technologie her bekannten Barrierematerialien auf das ganz spezielle technische Gebiet der vorliegenden Erfindung zu übertragen.

Allgemein gilt, dass die Aussenschichten 2,3 alternativ auch aus unterschiedlichen bevorzugten Polyamiden gebildet sein können.

### Bezugszeichen:

- 1: Photovoltaikmodul-Mehrschichtrückfolie
- 2: erste Aussenschicht
- 3: zweite Aussenschicht
- 4: erste Innenschicht
- 5: zweite Innenschicht
- 6: äussere Haftvermittlerschicht
- 7: erste innere Haftvermittlerschicht
- 8: dritte Innenschicht
- 9: zweite innere Haftvermittlerschicht

## Patentansprüche

1. Photovoltaikmodul-Mehrschichtrückfolie (1), die eine erste Aussenschicht (2), eine zweite Aussenschicht (3) und zumindest eine zwischen diesen Aussenschichten (2,3) angeordnete, eine Wasserdampfbarriere und/oder Sauerstoffbarriere bildende Innenschicht (4,5) umfasst, wobei diese Schichten (2,3,4,5) aus Polymeren aufgebaut sind, **dadurch gekennzeichnet, dass** zumindest eine der beiden Aussenschichten (2,3) der Photovoltaikmodul-Mehrschichtrückfolie (1) ein Polyamid ausgewählt aus der Gruppe PA 12, PA 11, PA 610, PA 612, PA 1010, PA 1012, PA MACM12 sowie deren Mischungen umfasst, wobei die Polyamide einer oder beider Aussenschichten mindestens ein Weisspigment als Zusatzstoff enthalten, **und dass** die zumindest eine Innenschicht (4,5) der Photovoltaikmodul-Mehrschichtrückfolie (1) aus Polymeren besteht, die ausgewählt sind aus der Gruppe, die aus PVDC, COC, PP, EVOH, PPS, PSU, PESU, PPSU, PEEK, LCP, PI, PAI und PBT besteht, wobei Innenschichten (4,5) aus PBT mittels mindestens einer äusseren Haftvermittlerschicht (6) aus Block-Copolyesteramid mit mindestens einer der Polyamid umfassenden Aussenschichten (2,3) verbunden sind.

2. Photovoltaikmodul-Mehrschichtrückfolie (1) nach Anspruch 1, **dadurch gekennzeichnet, dass** beide Aussenschichten (2,3) der Photovoltaikmodul-Mehrschichtrückfolie (1) aus einem Polyamid, vorzugsweise aus dem gleichen Polyamid, bestehen.

3. Photovoltaikmodul-Mehrschichtrückfolie (1) nach einem der vorhergehenden Ansprüche, **dadurch gekennzeichnet, dass** bei einer Innenschicht (4,5) aus COC das COC mit Maleinsäureanhydrid funktionalisiert ist.

4. Photovoltaikmodul-Mehrschichtrückfolie (1) nach einem der vorhergehenden Ansprüche, **dadurch gekennzeichnet, dass** sie zumindest zwei oder drei Innenschichten (4,5,8) umfasst, wobei im Fall von zumindest zwei Innenschichten eine Innenschicht (4,5) aus EVOH besteht, und die zweite bevorzugt aus PVDC.

5. Photovoltaikmodul-Mehrschichtrückfolie (1) nach einem der vorhergehenden Ansprüche, **dadurch gekennzeichnet, dass** zwischen zumindest einer Oberfläche einer Innenschicht (4,5,8) und einer inneren Oberfläche einer der beiden Aussenschichten (2,3) eine äussere Haftvermittlerschicht (6) angeordnet ist.

6. Photovoltaikmodul-Mehrschichtrückfolie (1) nach Anspruch 4 oder 5, **dadurch gekennzeichnet, dass** zwischen je einer Oberfläche einer ersten Innenschicht (4), zweiten Innenschicht (5) und/oder dritten Innenschicht (8) eine innere Haftvermittlerschicht (7,9) angeordnet ist.

7. Photovoltaikmodul-Mehrschichtrückfolie (1) nach Anspruch 5 oder 6, **dadurch gekennzeichnet, dass** das Material für die Haftvermittlerschichten (6,7,9) ausgewählt ist aus der Gruppe, die Acrylate, Epoxide, Polyurethane (PUR), funktionalisierte Polyolefine, Ionomere sowie Ethylenvinylacetat (EVA) umfasst.

8. Photovoltaikmodul-Mehrschichtrückfolie (1) nach einem der Ansprüche 1 oder 2, **dadurch gekennzeichnet, dass** das Material für die zumindest eine Innenschicht (4,5) PBT ist, wobei die angrenzende äussere Haftvermittlerschicht (6) aus Block-Copolyesteramid zu den ihr benachbarten Schichten (2,3,4,5) verträgliche Blöcke aufweist.

9. Photovoltaikmodul-Mehrschichtrückfolie (1) nach Anspruch 8, **dadurch gekennzeichnet, dass** die Blöcke der äusseren Haftvermittlerschicht (6) aus Block-Copolyesteramid dem PBT der Innenschicht (4,5) und dem Polyamid der Aussenschicht (2,3) entsprechen, an welche die äussere Haftvermittlerschicht (6) aus Block-Copolyesteramid grenzt.

10. Photovoltaikmodul-Mehrschichtrückfolie (1) nach einem der Ansprüche 8 oder 9, **dadurch gekennzeichnet, dass** sie eine Innenschicht (4) aus PBT umfasst, wobei die Innenschicht (4) beidseitig über je eine äussere Haftvermittlerschicht (6) aus Block-Copolyesteramid mit zwei Aussenschichten (2,3) aus Polyamid verbunden ist.

11. Photovoltaikmodul-Mehrschichtrückfolie (1) nach einem der Ansprüche 8 bis 10, **dadurch gekennzeichnet, dass** die Photovoltaikmodul-Mehrschichtrückfolie (1) coextrudiert ist.

12. Photovoltaikmodul-Mehrschichtrückfolie (1) nach einem der vorhergehenden Ansprüche, **dadurch gekennzeichnet, dass** die Polyamide einer oder beider Aussenschichten (2,3) mindestens einen weiteren Zusatzstoff enthalten, der ausgewählt ist aus einer Gruppe, die aus UV-Stabilisatoren, UV-Absorbern, Antioxidantien, Hitzestabilisatoren, Hydrolysestabilisatoren, Vernetzungsaktivatoren, Flammschutzmitteln, Schichtsilikaten, Füllstoffen, Farbmitteln, Verstärkungsmitteln, Haftvermittlern und Schlagzähigkeitsmodifikatoren besteht.

13. Photovoltaikmodul-Mehrschichtrückfolie (1) nach einem der vorhergehenden Ansprüche, **dadurch gekennzeichnet, dass** sie eine Reflektivität von mindestens 92 % aufweist.

14. Photovoltaikmodul-Mehrschichtrückfolie (1) nach einem der vorhergehenden Ansprüche, **dadurch gekennzeichnet, dass** das mindestens eine Weisspigment Titandioxid ist.

15. Photovoltaikmodul-Mehrschichtrückfolie (1) nach einem der vorhergehenden Ansprüche, **dadurch gekennzeichnet, dass** die Polymere bzw. Polyamide der Aussenschichten (2,3) aus vernetzten Polyamiden bestehen, wobei vernetztes PA 1010 und vernetztes PA 12 bevorzugte Werkstoffe sind.

16. Verfahren zur Herstellung einer Photovoltaikmodul-Mehrschichtrückfolie (1), die eine erste Aussenschicht (2) und eine zweite Aussenschicht (3) und zumindest eine zwischen diesen Aussenschichten (2,3) angeordnete, eine Wasserdampfbarriere und/oder Sauerstoffbarriere bildende Innenschicht (4,5) umfasst, **dadurch gekennzeichnet, dass** zumindest eine der beiden Aussenschichten (2,3) der Photovoltaikmodul-Mehrschichtrückfolie (1) aus einem Polyamid ausgewählt aus der Gruppe PA 12, PA 11, PA 610, PA 612, PA 1010, PA 1012, PA MACM12 sowie deren Mischungen gebildet wird, wobei die Polyamide einer oder beider Aussenschichten mindestens ein Weisspigment als Zusatzstoff enthalten, **und dass** die zumindest eine Innenschicht (4,5) der Photovoltaikmodul-Mehrschichtrückfolie (1) aus einem Polymer ausgewählt aus der Gruppe, die aus PVDC, COC, PP, EVOH, PPS, PSU, PESU, PPSU, PEEK, LCP, PI, PAI und PBT besteht, gebildet wird, wobei Innenschichten (4,5) aus PBT nur in Kombination mit einer äusseren Haftvermittlerschicht (6) aus Block-Copolyesteramid verwendet werden.

17. Verfahren zur Herstellung einer Photovoltaikmodul-Mehrschichtrückfolie (1) nach Anspruch 16, **dadurch gekennzeichnet, dass** die beiden Aussenschichten (2,3) aus je einer Polyamidformmasse extrudiert werden und auf die zumindest eine Innenschicht (4,5) coextrudiert, laminiert oder kaschiert werden, gegebenenfalls unter Verwendung von Haftvermittlerschichten.

18. Verfahren zur Herstellung einer Photovoltaikmodul-Mehrschichtrückfolie (1) nach Anspruch 16 oder 17, **dadurch gekennzeichnet, dass** sie aus zwei Aussenschichten (2,3) und zumindest zwei Innenschichten (4,5) gebildet wird, wobei eine der Innenschichten aus EVOH und die zweite bevorzugt aus PVDC gebildet wird.

19. Verfahren zur Herstellung einer Photovoltaikmodul-Mehrschichtrückfolie (1) nach einem der Ansprüche 16 bis 18, **dadurch gekennzeichnet, dass** zumindest eine der beiden Aussenschichten (2,3) auf eine Innenschicht (4) aus PVDC laminiert oder kaschiert wird, gegebenenfalls unter Verwendung von Haftvermittlerschichten.

20. Verfahren zur Herstellung einer Photovoltaikmodul-Mehrschichtrückfolie (1) nach einem der Ansprüche 16 bis 18, **dadurch gekennzeichnet, dass** zumindest eine der beiden Aussenschichten (2,3) auf eine Innenschicht (4) aus COC oder EVOH coextrudiert, laminiert oder kaschiert wird, gegebenenfalls unter Verwendung von Haftvermittlerschichten.

21. Verfahren zur Herstellung einer Photovoltaikmodul-Mehrschichtrückfolie (1) nach Anspruch 16, **dadurch gekennzeichnet, dass** die Photovoltaikmodul-Mehrschichtrückfolie (1) mittels Co-Extrusion hergestellt wird, wobei eine Innenschicht (4) aus PBT beidseitig über je eine äussere Haftvermittlerschicht (6) aus Block-Copolyesteramid mit zwei Aussenschichten (2,3) aus Polyamid verbunden wird.

22. Verfahren zur Herstellung einer Photovoltaikmodul-Mehrschichtrückfolie (1) nach einem der Ansprüche 16 bis 21, **dadurch gekennzeichnet, dass** einer Polyamidschmelze für die Aussenschichten (2,3) zur Erzielung einer Vernetzung des Polyamids ein Vernetzungsaktivator zugegeben wird.

23. Verfahren zur Herstellung einer Photovoltaikmodul-Mehrschichtrückfolie (1) nach Anspruch 16 bis 22, **dadurch gekennzeichnet, dass** die beiden Aussenschichten (2,3) als Folien extrudiert werden und eine Vernetzung an den extrudierten Folien durch energiereiche Bestrahlung, vorzugsweise durch Elektronenbestrahlung ausgelöst wird.

24. Verfahren zur Herstellung einer Photovoltaikmodul-Mehrschichtrückfolie (1) nach einem der Ansprüche 22 oder 23, **dadurch gekennzeichnet, dass** der Vernetzungsaktivator ausgewählt ist aus der Gruppe Trimethylolpropantrimethacrylat und Triallylisocyanurat.

25. Verwendung einer Photovoltaikmodul-Mehrschichtrückfolie (1) gemäss einem der Ansprüche 1 bis 15 bei der Produktion photovoltaischer Module.

## Claims

1. A multilayer backsheet (1) for a photovoltaic module, comprising a first outside layer (2), a second outside layer (3) and at least one inside layer (4, 5) which is arranged between these outside layers (2, 3) and forms a water-vapour barrier and/or oxygen barrier, wherein these layers (2, 3, 4, 5) are composed of polymers, **characterized in that** at least one of the two outside layers (2, 3) of the multilayer backsheet (1) for a photovoltaic module comprises a polyamide, selected from the group PA 12, PA 11, PA 610, PA 612, PA 1010, PA 1012 and PA MACM12, as well as mixtures thereof, wherein the polyamides of one or both outside layers contain at least one white pigment as additive, and that the at least one inside layer (4, 5) of the multilayer backsheet (1) for a photovoltaic module consists of polymers which are selected from the group consisting of PVDC, COC, PP, EVOH, PPS, PSU, PESU, PPSU, PEEK, LCP, PI, PAI, and PBT, wherein inside layers (4, 5) of PBT are connected by means of at least one outer adhesion promoter layer (6) made of block copolyester amide with at least one of the outside layers (2, 3) comprising polyamide.

2. The multilayer backsheet (1) for a photovoltaic module according to claim 1, **characterized in that** both outside layers (2, 3) of the multilayer backsheet (1) for a photovoltaic module consist of a polyamide, preferably the same polyamide.

3. The multilayer backsheet (1) for a photovoltaic module according to any one of the preceding claims, **characterized in that** in the case of one inside layer (4, 5) made of COC, the COC is functionalized with maleic acid anhydride.

4. The multilayer backsheet (1) for a photovoltaic module according to any one of the preceding claims, **characterized in that** it comprises at least two or three inside layers (4,5,8), wherein in the case of at least two inside layers, one inside layer (4, 5) consists of EVOH and the second one preferably consists of PVDC.

5. The multilayer backsheet (1) for a photovoltaic module according to any one of the preceding claims, **characterized in that** an outer adhesion promoter layer (6) is arranged between at least one surface of an inside layer (4, 5, 8) and an inner surface of one of the two outside layers (2,3).

6. The multilayer backsheet (1) for a photovoltaic module according to claim 4 or 5, **characterized in that** an inside adhesion promoter layer (7, 9) is arranged between one surface each of a first inside layer (4), second inside layer (5) and/or third inside layer (8).

7. The multilayer backsheet (1) for a photovoltaic module according to claim 5 or 6, **characterized in that** the material for the adhesion promoter layers (6, 7, 9) is selected from the group which comprises acrylates, epoxides, polyurethane (PUR), functionalized polyolefins, ionomers and ethylene vinyl acetate (EVA).

8. The multilayer backsheet (1) for a photovoltaic module according to any one of claims 1 or 2, **characterized in that** the material for the at least one inside layer (4, 5) is PBT, wherein the adjacent outer adhesion promoter layer (6) made of block copolyester amide has blocks compatible to layers (2, 3, 4, 5) adjacent to said adhesion promoter layer.

9. The multilayer backsheet (1) for a photovoltaic module according to claim 8, **characterized in that** the blocks of the outer adhesion promoter layer (6) made of block copolyester amide correspond to the PBT of the inside layer (4, 5) and to the polyamide of the outside layer (2, 3), on which the outer adhesion promoter layer (6) made of block copolyester amide borders.

10. The multilayer backsheet (1) for a photovoltaic module according to any one of claims 8 or 9, **characterized in that** it comprises an inside layer (4) made of PBT, wherein the inside layer (4) is connected on both sides by one outer adhesion promoter layer (6) each made of block copolyester amide with two outside layers (2, 3) made of polyamide.

11. The multilayer backsheet (1) for a photovoltaic module according to any one of claims 8 to 10, **characterized in that** the multilayer backsheet (1) for a photovoltaic module is co-extruded.

12. The multilayer backsheet (1) for a photovoltaic module according to any one of the preceding claims, **characterized in that** the polyamides of one or both outside layers (2, 3) contain at least one further additive which is selected from a group which consists of UV stabilizers, UV absorbers, antioxidants, heat stabilizers, hydrolysis stabilizers, cross-linking activators, flame retardants, layered silicates, fillers, colourants, reinforcing agents, adhesion promoters and impact modifiers.

13. The multilayer backsheet (1) for a photovoltaic module according to any one of the preceding claims, **characterized in that** it has a reflectivity of at least 92%.

14. The multilayer backsheet (1) for a photovoltaic module according to any one of the preceding claims, **characterized in that** the at least one white pigment is titanium dioxide.

15. The multilayer backsheet (1) for a photovoltaic module according to any one of the preceding claims, **characterized in that** the polymers or polyamides of the outside layers (2, 3) consist of cross-linked polyamides, wherein cross-linked PA 1010 and cross-linked PA 12 are preferred materials.

16. A method for producing a multilayer backsheet (1) for a photovoltaic module, comprising a first outside layer (2) and a second outside layer (3) and at least one inside layer (4, 5) which is arranged between these outside layers (2, 3) and forms a water-vapour barrier and/or oxygen barrier, **characterized in that** at least one of the two outside layers (2, 3) of the multilayer backsheet (1) for a photovoltaic module is formed from a polyamide selected from the group PA 12, PA 11, PA 610, PA 612, PA 1010, PA 1012 and PA MACM12, as well as mixtures thereof, wherein the polyamides of one or both outside layers contain at least one white pigment as additive, and that the at least one inside layer (4, 5) of the multilayer backsheet (1) for a photovoltaic module is formed from a polymer selected from the group consisting of PVDC, COC, PP, EVOH, PPS, PSU, PESU, PPSU, PEEK, LCP, PI, PAI, and PBT, wherein inside layers (4, 5) of PBT are only used in combination with an outer adhesion promoter layer (6) made of block copolyester amide.

17. The method for producing a multilayer backsheet (1) for a photovoltaic module according to claim 16, **characterized in that** the two outside layers (2, 3) are extruded from a polyamide moulding material each and are co-extruded or laminated or coated onto the at least one inside layer (4, 5), optionally by using adhesion promoter layers.

18. The method for producing a multilayer backsheet (1) for a photovoltaic module according to claim 16 or 17, **characterized in that** it is formed by two outside layers (2, 3) and at least two inside layers (4, 5), wherein one of the inside layers is formed of EVOH and the second is preferably formed of PVDC.

19. The method for producing a multilayer backsheet (1) for a photovoltaic module according to any one of claims 16 to 18, **characterized in that** at least one of the two outside layers (2, 3) is laminated or coated onto an inside layer (4) made of PVDC, optionally by using adhesion promoter layers.

20. The method for producing a multilayer backsheet (1) for a photovoltaic module according to any one of claims 16 to 18, **characterized in that** at least one of the two outside layers (2, 3) is co-extruded or laminated or coated onto an inside layer (4) made of COC or EVOH, optionally by using adhesion promoter layers.

21. The method for producing a multilayer backsheet (1) for a photovoltaic module according to claim 16, **characterized in that** the multilayer backsheet (1) for a photovoltaic module is produced by means of co-extrusion, wherein one inside layer (4) made of PBT is connected on both sides in each case by way of an outside adhesion promoter layer (6) made of block copolyester amide with two outside layers (2, 3) made of polyamide.

22. The method for producing a multilayer backsheet (1) for a photovoltaic module according to any one of claims 16 to 21, **characterized in that** a cross-linking activator is added to a polyamide melt for the outside layers (2, 3) in order to achieve cross-linking of the polyamide.

23. The method for producing a multilayer backsheet (1) for a photovoltaic module according to claims 16 to 22, **characterized in that** the two outside layers (2, 3) are extruded as films and cross-linking to the extruded films is triggered by high-energy irradiation, preferably by electron irradiation.

24. The method for producing a multilayer backsheet (1) for a photovoltaic module according to any one of claims 22 or 23, **characterized in that** the cross-linking activator is selected from the group of trimethylol propane trimethacrylate and triallyl isocyanurate.

25. Use of a backsheet (1) for a photovoltaic module according to any one of claims 1 to 15 in the production of photovoltaic modules.

## Revendications

1. Feuille arrière multicouche de module photovoltaïque (1) comprenant une première couche extérieure (2), une deuxième couche extérieure (3) et au moins une couche intérieure (4, 5) agencée entre ces couches extérieures (2, 3) et formant une barrière contre la vapeur d'eau et/ou une barrière contre l'oxygène, ces couches (2, 3, 4, 5) étant constituées de polymères, **caractérisée en ce qu'**au moins une des deux couches extérieures (2, 3) de la feuille arrière multicouche de module photovoltaïque (1) comprend un polyamide choisi à partir du groupe PA 12, PA 11, PA 610, PA 612, PA 1010, PA 1012, PA MACM12 ainsi que les mélanges de ces derniers, les polyamides de l'une ou des deux couches extérieures contenant au moins un pigment blanc comme additif, et **en ce que** la au moins une couche intérieure (4, 5) de la feuille arrière multicouche de module photovoltaïque (1) est composée de polymères qui sont choisis à partir du groupe composé de PVDC, COC, PP, EVOH, PPS, PSU, PESU, PPSU, PEEK, LCP, PI, PAI et PBT, les couches intérieures (4, 5) en PBT étant reliées à au moins une des couches extérieures (2, 3) comprenant de polyamide par le biais d'au moins une couche adhésive extérieure (6) en copolyesteramide en blocs.

2. Feuille arrière multicouche de module photovoltaïque (1) selon la revendication 1, **caractérisée en ce que** les deux couches extérieures (2, 3) de la feuille arrière multicouche de module photovoltaïque (1) sont composées à partir d'un polyamide, de préférence à partir du même polyamide.

3. Feuille arrière multicouche de module photovoltaïque (1) selon l'une des revendications précédentes, **caractérisée en ce que**, avec une couche intérieure (4, 5) en COC, le COC est fonctionnalisé avec de l'anhydre d'acide maléique.

4. Feuille arrière multicouche de module photovoltaïque (1) selon l'une des revendications précédentes, **caractérisée en ce qu'**elle comprend au moins deux ou trois couches intérieures (4, 5, 8), dans laquelle, dans le cas d'au moins deux couches intérieures, une couche intérieure (4, 5) est composée de EVOH et la deuxième est composée de préférence de PVDC.

5. Feuille arrière multicouche de module photovoltaïque (1) selon l'une des revendications précédentes, **caractérisée en ce qu'**il est agencé entre au moins une surface d'une couche intérieure (4, 5, 8) et une surface intérieure de l'une des deux couches extérieures (2, 3) une couche adhésive extérieure (6).

6. Feuille arrière multicouche de module photovoltaïque (1) selon la revendication 4 ou 5, **caractérisée en ce qu'**il est agencé entre une surface d'une première couche intérieure (4), d'une deuxième couche intérieure (5) et/ou d'une troisième couche intérieure (8) une couche adhésive intérieure (7, 9).

7. Feuille arrière multicouche de module photovoltaïque (1) selon la revendication 5 ou 6, **caractérisée en ce que** le matériau pour les couches adhésives (6, 7, 9) est choisi à partir du groupe comprenant des acrylates, des époxydes, des polyuréthanes (PUR), des polyoléfines fonctionnalisées, des ionomères ainsi que l'éthylène-acétate de vinyle (EVA).

8. Feuille arrière multicouche de module photovoltaïque (1) selon l'une des revendications 1 ou 2, **caractérisée en ce que** le matériau pour la au moins une couche intérieure (4, 5) est du PBT, la couche adhésive extérieure adjacente (6) en copolyesteramide en blocs présentant au niveau des couches qui lui sont adjacentes (2, 3, 4, 5) des blocs compatibles.

9. Feuille arrière multicouche de module photovoltaïque (1) selon la revendication 8, **caractérisée en ce que** les blocs de la couche adhésive extérieure (6) en copolyesteramide en blocs correspondent au PBT de la couche intérieure (4, 5) et au polyamide de la couche extérieure (2, 3) auxquelles est attenante la couche adhésive extérieure (6) en copolyesteramide en blocs.

10. Feuille arrière multicouche de module photovoltaïque (1) selon l'une des revendications 8 ou 9, **caractérisée en ce qu'**elle comprend une couche intérieure (4) en PBT, la couche intérieure (4) étant reliée de chaque côté à deux couches extérieures (2, 3) en polyamide par le biais d'une couche adhésive extérieure (6) en copolyesteramide en blocs.

11. Feuille arrière multicouche de module photovoltaïque (1) selon l'une des revendications 8 à 10, **caractérisée en ce que** la feuille arrière multicouche de module photovoltaïque (1) est coextrudée.

12. Feuille arrière multicouche de module photovoltaïque (1) selon l'une des revendications précédentes, **caractérisée en ce que** les polyamides de l'une ou des deux couches extérieures (2, 3) contiennent au moins un autre additif qui est choisi à partir du groupe composé de stabilisateurs UV, absorbeurs d'UV, antioxydants, stabilisateurs thermiques, stabilisateurs d'hydrolyse, activateurs de réticulation, retardateurs de flamme, silicates lamellaires, matières de remplissage, colorants, agents de renforcement, adhésifs et agents modifiant la résistance aux chocs.

13. Feuille arrière multicouche de module photovoltaïque (1) selon l'une des revendications précédentes, **caractérisée en ce qu'**elle présente une réflectivité d'au moins 92 %.

14. Feuille arrière multicouche de module photovoltaïque (1) selon l'une des revendications précédentes, **caractérisée en ce que** le au moins un pigment blanc est du dioxyde de titane.

15. Feuille arrière multicouche de module photovoltaïque (1) selon l'une des revendications précédentes, **caractérisée en ce que** les polymères ou les polyamides des couches extérieures (2, 3) sont composés de polyamides réticulés, le PA 1010 réticulé et le PA 12 réticulé étant des matières préférées.

16. Procédé pour fabriquer une feuille arrière multicouche de module photovoltaïque (1) qui comprend une première couche extérieure (2) et une deuxième couche extérieure (3) et au moins une couche intérieure (4, 5) agencée entre ces couches extérieures (2, 3) et formant une barrière contre la vapeur d'eau et/ou une barrière contre l'oxygène, **caractérisé en ce qu'**au moins l'une des deux couches extérieures (2, 3) de la feuille arrière multicouche de module photovoltaïque (1) est constituée d'un polyamide choisi parmi le groupe PA 12, PA 11, PA 610, PA 612, PA 1010, PA 1012, PA MACM12 et les mélanges de ces derniers, les polyamides d'une ou des deux couches extérieures contenant au moins un pigment blanc comme additif, et **en ce que** la au moins une couche intérieure (4, 5) de la feuille arrière multicouche de module photovoltaïque (1) est constituée d'un polymère choisi à partir du groupe constitué de PVDC, COC, PP, EVOH, PPS, PSU, PESU, PPSU, PEEK, LCP, PI, PAI et PBT, les couches intérieures (4, 5) en PBT étant utilisées uniquement en combinaison avec une couche adhésive extérieure (6) en copolyesteramide en blocs.

17. Procédé pour fabriquer une feuille arrière multicouche de module photovoltaïque (1) selon la revendication 16, **caractérisé en ce que** les deux couches extérieures (2, 3) sont extrudées chacune à partir d'une matière à mouler de polyamide et sont coextrudées, laminées ou stratifiées sur la au moins une couche intérieure (4, 5), le cas échéant en utilisant des couches adhésives.

18. Procédé pour fabriquer une feuille arrière multicouche de module photovoltaïque (1) selon la revendication 16 ou 17, **caractérisé en ce qu'**elle est composée de deux couches extérieures (2, 3) et d'au moins deux couches intérieures (4, 5), l'une des couches intérieures étant constituée de EVOH et la deuxième étant de préférence constituée de PVDC.

19. Procédé pour fabriquer une feuille arrière multicouche de module photovoltaïque (1) selon l'une des revendications 16 à 18, **caractérisé en ce qu'**au moins une des deux couches extérieures (2, 3) est laminée ou stratifiée sur une couche intérieure (4) en PVDC, le cas échéant en utilisant des couches adhésives.

20. Procédé pour fabriquer une feuille arrière multicouche de module photovoltaïque (1) selon l'une des revendications 16 à 18, **caractérisé en ce qu'**au moins une des deux couches extérieures (2, 3) est coextrudée, laminée ou stratifiée sur une couche intérieure (4) en COC ou EVOH, le cas échéant en utilisant des couches adhésives.

21. Procédé pour fabriquer une feuille arrière multicouche de module photovoltaïque (1) selon la revendication 16, **caractérisé en ce que** la feuille arrière multicouche de module photovoltaïque (1) est fabriquée par coextrusion, une couche intérieure (4) en PBT étant raccordée de chaque côté à deux couches extérieures (2, 3) en polyamide par le biais d'une couche adhésive extérieure (6) en copolyesteramide en blocs.

22. Procédé pour fabriquer une feuille arrière multicouche de module photovoltaïque (1) selon l'une des revendications 16 à 21, **caractérisé en ce qu'**il est ajouté à une masse fondue de polyamide pour les couches extérieures (2, 3) un activateur de réticulation en vue d'obtenir une réticulation du polyamide.

23. Procédé pour fabriquer une feuille arrière multicouche de module photovoltaïque (1) selon les revendications 16 à 22, **caractérisé en ce que** les deux couches extérieures (2, 3) sont extrudées sous la forme de feuilles et **en ce qu'**il est déclenché une réticulation au niveau des feuilles extrudées par un rayonnement à haute énergie, de préférence par irradiation aux électrons.

24. Procédé pour fabriquer une feuille arrière multicouche de module photovoltaïque (1) selon l'une des revendications 22 ou 23, **caractérisé en ce que** l'activateur de réticulation est choisi à partir du groupe composé de triméthacrylate de triméthylolpropane et triallylisocyanurate.

25. Utilisation d'une feuille arrière multicouche de module photovoltaïque (1) selon l'une des revendications 1 à 15 pour la production de modules photovoltaïques.
